# EUROPÄISCHE PATENTSCHRIFT

(11) **EP 0 913 940 B1**
(45) Veröffentlichungstag und Bekanntmachung des Hinweises auf die Patenterteilung: **11.09.2002**
(21) Anmeldenummer: 98119830.2
(22) Anmeldetag: 20.10.1998
(51) Int. Cl.: H03K 17/968

(54) **Vorrichtung zum Erfassen von Schaltstellungen eines mechanisch betätigbaren Schaltmittels sowie Verfahren zum Erfassen von Schaltstellungen eines mechanisch betätigbaren Schaltmittels**
Method and device for detecting the switching positions of a mechanically activated switch
Procédé et circuit pour détecter les positions de commutation d'un commutateur actionné mécaniquement

(30) Priorität: 31.10.1997 DE 19748131
(43) Veröffentlichungstag der Anmeldung: 06.05.1999
(73) Patentinhaber: Leopold Kostal GmbH & Co. KG, 58507 Lüdenscheid (DE)
(72) Erfinder: Bläsing, Frank Dipl.-Ing., 59457 Werl (DE); Bendicks, Norbert Dipl.-Ing., 58675 Hemer (DE); Garneyer, Stefan Dipl.-Ing., 58097 Hagen (DE); Hirschfeld, Klaus Dipl.-Ing., 58511 Lüdenscheid (DE); Böbel, Ralf Dipl.-Ing., 44269 Dortmund (DE); Laubrock, Arno Dipl.-Ing., 44139 Dortmund (DE)
(74) Vertreter: Schröter & Haverkamp

(56) Entgegenhaltungen:
- EP-A- 0 348 816
- DE-A- 4 108 388
- DE-C- 4 339 931
- US-A- 4 782 327

## Beschreibung

Die Erfindung bezieht sich auf das Gebiet des Erfassens bestimmter Stellungen von beweglichen Teilen zueinander. Insbesondere betrifft die Erfindung eine Vorrichtung zum Erfassen von Schaltstellungen eines mechanisch betätigbaren, zwangsgeführten Schaltmittels. Ferner betrifft die Erfindung ein Verfahren zum Erfassen von Schaltstellungen eines mechanisch betätigbaren, zwangsgeführten, mehraxial bewegbaren Schaltmittels.

Vorrichtungen zum Erfassen von Schaltstellungen werden etwa bei Schaltern verwendet, denen mehrere Funktionen zukommen, um für einen Benutzer erkennbar zu machen, in welcher Schalt- bzw. Schalterstellung sich ein solcher Multifunktionsschalter befindet. Derartige Schalter werden beispielsweise als Beleuchtungs- oder Lenkstockschalter in Kraftfahrzeugen eingesetzt. Damit die Vielzahl der Funktionen unabhängig voneinander und parallel zueinander ausgeführt werden können, können solche Schalter in mehreren Ebenen drehbar ausgestaltet. Zur Darstellung der jeweiligen Schalterstellung kann dem Schalter ein hinterleuchteter Symbolkranz zugeordnet sein, wobei in Abhängigkeit von der jeweiligen Schalterstellung das oder die Symbole hinterleuchtet sind, die für die tatsächlich eingeschaltete Beleuchtung stehen. Die Erfassung der jeweiligen Schalterstellung erfolgt somit mechanisch.

Derartige Schalter sind herkömmlich als Kontaktschalter ausgelegt, so daß eine Schalterstellung dann erreicht ist, wenn durch das Schaltorgan die entsprechende elektrische Verbindung hergestellt ist. Auch wenn mit einem solchen Multifunktionsschalter eine Vielzahl unterschiedlicher Funktionen schaltbar sind, so erhöht sich der Aufwand bei komplizierten Schalterstrukturen unverhältnismäßig, wenn die jeweiligen Schalterstellungen auf die oben beschriebene Weise erfaßt werden sollen. Dabei kann eine Schaltstellungserfassung nicht nur dazu dienen, diese einem Benutzer erkennbar zu machen, sondern die jeweilige Schaltstellung soll auch als Dateneingang einer Datenverarbeitungsanlage, etwa einem Bordcomputer bei Kraftfahrzeugen für Überwachungs- und Steuerungszwecke zugänglich gemacht werden. Für derartige Zwecke ist die oben beschriebene Schalterstellungserfassung jedoch nicht vorgesehen.

Multifunktionsschalter können, wie aus der DE 43 32 748 A1 oder der EP 0 379 732 A1 bekannt, als kontaktlos arbeitende optische Schalter ausgebildet sein. Die in diesen Dokumenten beschriebenen Schalter zeichnen sich dadurch aus, daß zur Erfassung einer Schaltstellung keine elektrische Kontaktierung herbeigeführt werden muß, sondern daß ein photosensitives Element lichtbeaufschlagt ist, wenn sich das Schaltmittel in einer bestimmten Schaltposition befindet. Ein solcher optischer Schalter umfaßt neben dem photosensitiven Element eine Lichtquelle, die beispielsweise auf derselben Platine wie das photosensitive Element angeordnet sein kann. Mittels eines Lichtleitkörpers, dessen lichtauskoppelseitige Fläche zur photosensitiven Oberfläche des photoelektrischen Elementes weisend angeordnet ist, wird das benötigte Licht zu dem photoelektrischen Element gebracht. Zwischen der Auskoppelseite des Lichtleitkörpers und dem photoelektrischen Element ist ein Bewegungsspalt vorgesehen, in dem eine an die Bewegung des Schaltmittels gekoppelte Blende bewegbar ist. Die Blende weist an vorgegebener Position eine Durchbrechung auf, so daß nach einem Bewegen des Schaltmittels in eine bestimmte Schaltstellung die Durchbrechung mit der auskoppelseitigen Fläche des Lichtleitkörpers und der photosensitiven Oberfläche des photoelektrischen Elementes fluchtet, so daß letzteres lichtbeaufschlagbar ist. Wird das Schaltmittel aus dieser Position wieder heraus bewegt, ist das photoelektrische Element abgeschattet und die Schaltstellung verlassen. Durch entsprechendes Anordnen mehrerer derartiger optischer Schalter lassen sich mitunter auch komplizierte Schaltbewegungen erfassen.

Aus US 4 782 327 A ist eine Computercontrolleinrichtung bekannt, bei der ebenfalls eine optoelektronisch arbeitende Schaltstellungserfassungseinrichtung enthalten ist. Beim Gegenstand dieses Dokumentes handelt es sich um einen optischen Schalter, der nach Art einer Gabellichtschranke ausgebildet ist. Zu der einen Seite des beweglichen Geberelementes ist als Lichtquelle eine LED und zu der anderen Seite des Geberelementes ein Phototransistor angeordnet. Zwischen dem beweglichen Geberelement und dem Phototransistor ist ein feststehendes Blendenelement mit einer Blendenöffnung angeordnet, die den Öffnungen in der Geberscheibe entspricht. Das Geberelement umfaßt eine Vielzahl von hintereinanderliegenden gleichartigen Öffnungen, so daß bei einer Bewegung des Geberelementes relativ zum Phototransistor dieser entsprechend einer sinusförmigen Helligkeitskurve belichtet wird. Der sinusförmige Helligkeitsverlauf auf der photosensitiven Seite des Phototransistors ergibt sich ausgehend von einer abgeschatteten Stellung dadurch, daß bei einer Bewegung des Geberelementes sukzessive eine Öffnung des Geberelementes sich LED-seitig vor die Blendenöffnung schiebt und somit zunehmend mehr Licht zum Belichten des Phototransistors durchläßt. Mit maximaler Helligkeit ist der Phototransistor belichtet, wenn die Blendenöffnung und die Öffnung des Geberelementes fluchtend zueinander angeordnet sind. Bei einer weiteren Bewegung des Geberelementes nimmt durch die kleiner werdende lichtdurchlässige Öffnung die Helligkeit wieder ab. Somit ist grundsätzlich die von dem Phototransistor erfaßte Helligkeit ein Maß für die Stellung einer Öffnung des Geberelementes zur Blendenöffnung. Eine Erfassung der absoluten Stellung des Geberelementes bezogen auf die gesamte mögliche Bewegungsstrecke des Geberelementes ist mit der aus der US 4 782 337 bekannten Vorrichtung nicht möglich.

Bei dem Gegenstand der US 4 782 337 handelt es sich um einen zweidimensionalen Inkrementalgeber, wobei eine Auflösung beschränkt ist auf ein diskretes Codierungselement. Eine Positionsbestimmung des Geberelementes relativ zu dem ortsfesten Phototransistor innerhalb eines diskreten Elementes kann nur in Abhängigkeit von dem erfaßten Helligkeitsverlauf erfolgen, um auf diese Weise bestimmen zu können, in welchem Kurventeil des Helligkeitsverlaufs eines diskreten Elementes die Geberscheibe zu der Blendenöffnung angeordnet ist.. Daher muß diese vorbekannte Einrichtung entweder ständig in Betrieb sein, um kontinuierlich den erfaßten Helligkeitsverlauf zu erfassen, oder bei jeder erneuten Inbetriebnahme neu kalibriert werden.

Ferner ist aus der DE 41 08 388 A1 eine Einrichtung zur berührungslosen Erfassung von Schaltpositionen eines Schaltmittels bekannt. Diese Schalteinrichtung arbeitet prinzipiell nach demselben Prinzip wie die aus den oben genannten Dokumenten bekannten Schalter. Im Unterschied zu den zuvor diskutierten Schaltern ist die Lichtquelle unmittelbar an dem Schaltmittel angeordnet, so daß diese entsprechend der Bewegung des Schaltmittels mit bewegt wird. Befindet sich das Schaltmittel in einer vorbestimmten Schaltstellung, dann wird ein dieser Schaltstellung zugeordnetes photoelektrisches Element lichtbeaufschlagt, wodurch wiederum diese Schalterstellung erfaßbar ist.

Diese vorbekannten Schaltstellungserfassungsvorrichtungen weisen jedoch Nachteile auf. Zum einen können Schaltstellungen lediglich an denjenigen Positionen erfaßt werden, die durch photoelektrische Elemente gekennzeichnet sind. Schalterzwischenstellungen können nur mit einem zusätzlichen Aufwand, nämlich nur mit einem Einsatz zusätzlicher photoelektrischer Elemente erfaßt werden. Darüberhinaus eigenen sich die bekannten Schaltstellungserfassungsvorrichtungen nur bedingt zum Einsatz in beengten Raumverhältnissen, wie dies beispielsweise bei einer zentralen Erfassung der Schaltstellungen eines Lenkstockschalters notwendig wäre. Im Zuge einer mitunter langjährigen Benutzung eines solchen Schalters ergeben sich Verschleißerscheinungen im Hinblick auf die mechanische Führung des Schaltmittels. Folglich können sich die mechanisch fixierten Schaltpunkte verlagern, so daß die photoelektrischen Elemente in dieser Schaltstellung nicht mehr lichtbestrahlt sind. Ein bestimmungsgemäßes Schalten ist dann nicht mehr möglich.

Ausgehend von diesem diskutierten Stand der Technik liegt der Erfindung daher zum einen die Aufgabe zugrunde, eine Vorrichtung zum Erfassen von Schaltstellungen eines mechanisch betätigbaren, zwangsgeführten Schaltmittels vorzuschlagen, bei dem eine absolute Stellung des relativ beweglichen Elementes zu dem ortsfesten Element über den gesamten Bewegungsbetrag hinweg möglich ist, bei dem eine freie und somit auch alterungsadaptive Einstellung der zu erfassenden Schaltpunkte möglich ist.

Ferner liegt der Erfindung die Aufgabe zugrunde, ein Verfahren zum Erfassen von Schaltstellungen eines mechanisch betätigbaren, zwangsgeführten, mehraxial bewegbaren Schaltmittels vorzuschlagen, mit dem nicht nur eine freie, alterungsadaptive Einstellung der Schaltpunkte möglich ist, sondern mit der unter Verzicht auf zusätzliche funktionsüberprüfende Maßnahmen auch eine redundante Schaltstellungserfassung möglich ist.

Die erstgenannte Aufgabe wird erfindungsgemäß durch eine Vorrichtung zum Erfassen von Schalterstellungen eines mechanisch betätigbaren, zwangsgeführten Schaltmittels gemäß den Merkmalen des Anspruchs 1 gelöst.

Die verfahrensbezogene Aufgabe wird erfindungsgemäß durch ein Verfahren zum Erfassen von Schaltstellungen eines mechanisch betätigbaren, zwangsgeführten, mehraxial bewegbaren Schalters mit den Merkmalen des Anspruchs 13 gelöst.

Bei der erfindungsgemäßen Vorrichtung zum Erfassen von Schaltstellungen eines zwangsgeführten Schaltmittels ist im Gegensatz zum vorbekannten Stand der Technik eine bildliche Erfassung einer durch die Lichtstruktur bei einer Lichtbestrahlung auf der photosensitiven Oberfläche eines Sensorarrays abgebildete Lichtstruktur vorgesehen. Die Lichtstruktur ist so ausgebildet, daß in jeder Position des Geberelementes zu dem Sensorarray eine eindeutige Positionsbestimmung relativ zueinander möglich ist. Erreicht wird dies zum einen dadurch, daß anstelle eines einzelnen Phototransistors - wie beim Gegenstand der D1 - ein eine Vielzahl von einzelnen Bildpunkten aufweisendes Sensorarray eingesetzt ist, dessen Auflösungsvermögen ausgelegt ist, um die Unterschiede in den einzelnen Schaltstellung der Lichtstrukturen zu erfassen. Üblicherweise ist das Auflösungsvermögen eines solchen Sensorarrays, welches beispielsweise als Zeilen- oder als Flächensensor ausgebildet sein kann, ein Vielfaches höher als die zu erfassenden Änderungen in der Lichtstruktur. Das bildliche Abbilden einer sich in den unterschiedlichen Schaltstellungen unterschiedlich darstellenden Lichtstruktur erlaubt eine Positionsbestimmung über den gesamten Bewegungsbetrag des beweglichen Elementes hinweg, so daß diese Vorrichtung nach einer erstmaligen Kalibrierung grundsätzlich nicht neu kalibriert werden muß, auch wenn die Vorrichtung abgeschaltet ist. Somit ist eine Schaltstellungserfassung situationsabhängig und nicht wie beim vorbekannten Stand der Technik bewegungsabhängig möglich.

Als Sensorarray kann beispielsweise eine optische Sensorzeile oder ein Flächensensor dienen. Eine Bestimmung der jeweilig abzutastenden Schaltstellung in Anpassung an eine ggf. durch eine Rastung vorbestimmte mechanische Stellung des Schaltmittels kann Software-gesteuert erfolgen. Eine exakte Schaltstellungsbestimmung kann daher nach einer Montage des Schaltmittels und der ihm zugeordneten Schaltstellungserfassungsvorrichtung erfolgen, so daß Toleranzen und Ungenauigkeiten hinsichtlich der Anordnung von Sensorarray und Geberelement ausgleichbar sind. Entsprechend kann auch eine alterungsbedingte Dejustage einer solchen Vorrichtung Software-seitig korrigiert werden. Dabei ist es vorteilhaft, der Prozessoreinheit eine Speichereinheit zuzuordnen, in der zeitlich ältere Daten der Abtastung einer Schaltstellung abgelegt sind, so daß eine zeitlich rekursive Filterung hinsichtlich dieser Daten möglich ist. Dies erlaubt, eine solche Schaltstellungserfassungsvorrichtung selbstlernend sich an eine allmähliche ändernde mechanische Schaltstellung anpassend auszubilden. In einem Ausführungsbeispiel ist vorgesehen, daß von dem Sensorarray immer nur ein Ausschnitt der durch Bestrahlen des Geberelementes erzeugten Lichtstruktur abgetastet wird. Eine solche Ausgestaltung ist insbesondere dann vorteilhaft, wenn lange Schaltwege zwischen den einzelnen Schaltstellungen mit dem Schaltmittel bewältigt werden müssen, wie dies beispielsweise bei einer Fahrstufeneinstellung von Automatikgetrieben der Fall ist. Ein für einen solchen Anwendungsfall vorgesehenes Geberelement ist entsprechend lang ausgebildet und es wäre unzweckmäßig, daß Sensorarray die Bewegung des Geberelementes abdeckend noch größer vorzusehen. Aus diesem Grunde ist die auf dem Geberelement angeordnete durch Lichtbestrahlung erzeugte Lichtstruktur so ausgebildet, daß in den unterschiedlichen den Schaltstellungen entsprechenden Anordnungen zwischen Sensorarray und Geberelement bzw. dessen Strukturen in jeder zu erfassenden Schaltstellung eine sich eindeutig von den anderen Schaltstellungen unterscheidende Lichtstruktur abgetastet wird. Als Informationsredundanz ist vorgesehen, daß die Auflösung des Sensorarrays einem Mehrfachen der Schaltstellungsunterschiede entspricht.

Zur weiteren Erhöhung der Informationsredundanz kann bei Verwendung einer optischen Sensorzeile als Sensorarray vorgesehen sein, eine zusätzliche optische Sensorzeile, die parallel zur ersten optischen Sensorzeile angeordnet ist, zu verwenden. Die Erfassung der Lichtstruktur in zwei benachbarten Querschnitten erhöht ohne großen zusätzlichen Aufwand die Bereitstellung einer ausreichenden redundanten Schaltstellungserfassung.

In einer vorteilhaften Ausgestaltung ist vorgesehen, daß die Lichtstruktur zumindest zwei voneinander beabstandete, bezüglich ihres Abstandes konvergierende Hell-Dunkel-Übergangsspuren aufweist, bezüglich denen das Sensorarray dergestalt angeordnet ist, daß bei einer Relativbewegung zwischen dem Geberelement und dem Sensorarray der sich ändernde Abstand der Hell-Dunkel-Übergangsspuren von dem Sensorelement abtastbar ist. Eine solche Lichtstruktur kann sehr einfach aufgebaut sein und stellt daher nur geringe Anforderung an die Herstellung eines eine solche Lichtstruktur aufweisenden Geberelementes. Dabei kann der Abstand der konvergierenden Hell-Dunkel-Übergangsspuren linear oder auch einer Kurve entsprechend vorgesehen sein. In einer weiteren Ausgestaltung kann vorgesehen sein, daß die Lichtstruktur zwei voneinander getrennte Lichtspuren umfaßt, die konvergierend zueinander angeordnet sind. Bei beiden Ausgestaltungen ist es möglich, die Hell-Dunkel-Übergangsspuren in Richtung ihrer Verjüngung entweder kontinuierlich oder auch diskontinuierlich auszubilden. Der Vorteil einer diskontinuierlichen Ausgestaltung liegt insbesondere in dem Vorhandensein von Stegen zwischen einzelnen Lichtstrukturen erzeugenden, die Hell-Dunkel-Übergangsspuren bildenden Ausnehmungen, die zu einer Erhöhung der mechanischen Stabilität des Geberelementes beitragen.

In einer Weiterbildung ist vorgesehen, daß benachbart zu einer oder mehreren der Hell-Dunkel-Übergangsspuren weitere Lichtstrukturen angeordnet sind. Eine solche Maßnahme kann sowohl zur Erhöhung der Redundanz der abgetasteten Information einer Schaltstellung beitragen, als auch dazu dienen, bei einem Schaltmittel, welches mehraxial mechanisch betätigbar ist, eine Informationsredundanz in einer von der Erstreckung der ersten Lichtstrukturen unterschiedlichen Richtung zu erhalten.

In einem weiteren Ausführungsbeispiel ist vorgesehen, daß die photosensitive Oberfläche des Sensorarrays größer ist als der Bewegungsbereich der Lichtstruktur. Eine solche Ausgestaltung ist insbesondere dann zweckmäßig, wenn durch die Lichtstruktur bzw. das Geberelement nur sehr kleine Wege zurückgelegt werden, wie dies beispielsweise bei einem Einsatz einer erfindungsgemäßen Schaltstellungserfassungsvorrichtung in einem Lenkstockschalter der Fall ist. Zweckmäßigerweise wird bei einer solchen Ausgestaltung als Sensorarray ein Flächensensor eingesetzt. Für den Fall einer Verwendung einer solchen Schaltstellungserfassungsvorrichtung in einem Lenkstockschalter ist es zweckmäßig, das Geberelement an dem kurzen Hebelarm des Lenkstockschalters anzuordnen. Die Bewegungen des kurzen Hebelarmes sind dementsprechend gering. Zur Erhöhung des Auflösungsvermögens, wobei das Geberelement dreidimensional bewegbar angeordnet ist, ist es zweckmäßig, die die Lichtstruktur bildenden Lichtstrahlen vor ihrem Auftreffen auf die photosensitive Oberfläche des Sensorarrays an einer reflektierenden Oberfläche zu brechen, da auf diese Weise der Weg der Lichtstrahlen verlängert und Winkelstellungsunterschiede der in dem Geberelement enthaltenen Lichtstruktur sich in einem größeren Versatz bemerkbar machen.

Die Vorteile hinsichtlich des erfindungsgemäßen Verfahrens beruhen insbesondere auf der Möglichkeit der Software-mäßigen Justage des zur Schaltstellungserfassung verwendeten optoelektronischen Positionserfassungssystems sowie in der verfahrensmäßigen Möglichkeit, ebenfalls Schaltstellungen, die in unterschiedlichen Richtungen winklig, zu einer ersten Schaltstellungserfassungsrichtung angeordnet sind, erfassen zu können. Zu diesem Zweck kann der Querversatz der abgetasteten Lichtstrukturen zwischen dem Geberelement und dem Sensorarray durch Abtastung des Pixelversatzes einer Lichtspur bestimmt werden. Ebenfalls ist es möglich, anstelle einer Abtastung des Pixelversatzes der Lichtspur den Pixelversatz eines oder beider der zuerst abgetasteten Hell-Dunkel-Übergänge zu verfolgen oder es erfolgt eine Bestimmung der Hell-Dunkel-Übergangsmitte (Flankenmitte) und deren Lage bzw. deren Abstand auf der optischen Sensorzeile bzw. dem Flächensensor bezüglich eines Zeilenanfanges.

Weitere Vorteile und Ausgestaltungen sind Bestandteil der übrigen Unteransprüche sowie der nachfolgenden Beschreibung eines Ausführungsbeispieles. Es zeigen:
- **Fig. 1**: Eine schematisierte Darstellung einer Schalteinrichtung für ein Automatikgetriebe eines Kraftfahrzeuges mit einer Schaltstellungserfassungsvorrichtung,
- **Fig. 2**: eine vereinfachte Darstellung der Schaltstellungserfassungsvorrichtung der Figur 1 in einer ersten Schaltstellung,
- **Fig. 2a**: ein Diagramm eines Sensorarraysignales bezüglich einer Schaltstellung,
- **Fig. 3**: die Schaltstellungserfassungsvorrichtung der Figur 2 in einer weiteren Schaltstellung,
- **Fig. 4**: ein schematisiertes Blockschaltbild zur Erfassung unterschiedlicher Schaltstellungen einer Schaltstellungserfassungsvorrichtung und
- **Fig. 5**: einem schematisierten Querschnitt durch einen Lenkstockschalter mit einer optoelektronischen Schaltstellungserfassungsvorrichtung und
- **Fig. 6**: eine Draufsicht in den oberseitig geöffneten Lenkstockschalter der Figur 5.

Eine Schalteinrichtung 1 für ein Automatikgetriebe eines Kraftfahrzeuges umfaßt einen Schalthebel 2, der in einem nicht näher dargestellten Lagerbock gemäß den Pfeilrichtungen schwenkbar angelenkt ist. Der Schalteinrichtung 1 ist eine Schaltstellungserfassungsvorrichtung 3 (hier: Gangerkennungsschalter) zugeordnet. Die Schalterfassungsvorrichtung 3 besteht im wesentlichen aus einer Geberscheibe 4, die an dem Schalthebel 2 befestigt und somit an die Schwenkbewegungen des Schalthebels 2 gekoppelt ist. Unterhalb der Geberscheibe 4 ist eine nach oben abstrahlende Beleuchtungseinrichgung 5 angeordnet. Oberhalb der Geberscheibe 4 ist eine als Sensorarray vorgesehene optische Sensorzeile 6 zur Abtastung des von der Beleuchtungseinrichtung 5 emittierten durch die Geberscheibe tretenden Lichtes angeordnet. Die Beleuchtungseinrichtung 5 und die optische Sensorzeile 6 sind ortsfest bezüglich der Geberscheibe 4 am Lagerbock befestigt. Die optische Sensorzeile 6 ist an eine Prozessoreinheit 7 angeschlossen. Als optische Sensorzeile kann in Abwandlung von der optischen Sensorzeile 6 auch eine solche verwendet werden, deren einzelne Pixel frei adressierbar und auslesbar sind.

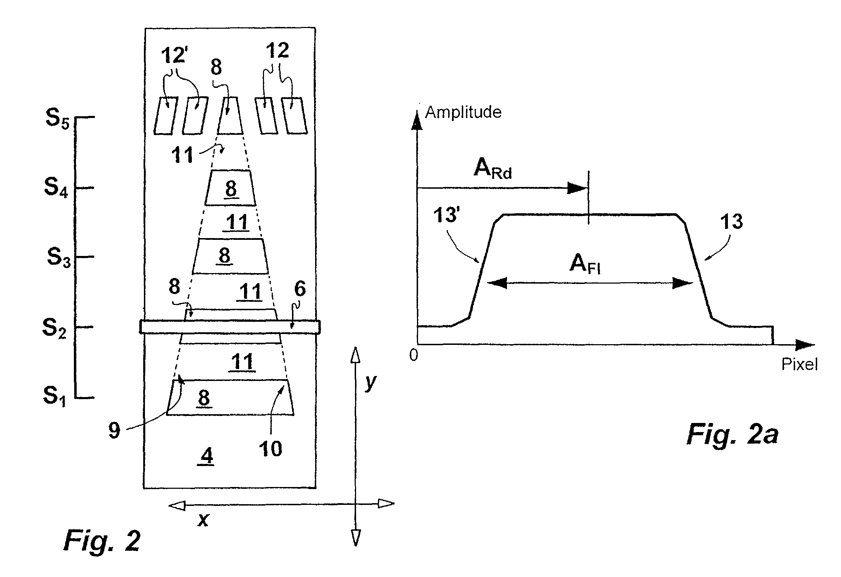

In die Geberscheibe 4 sind, wie in Figur 2 gezeigt, Ausnehmungen 8 eingebracht, deren sich in y-Richtung verjüngende Hell-Übergangsspuren 9, 10 die Hell-Dunkel-Übergänge einer Schaltstellung S₁₋₅ definieren. Bei der in den Figuren dargestellten Geberscheibe 4 handelt es sich um eine solche, bei der die Hell-Dunkel-Übergangsspuren 9, 10 in Richtung ihrer Verjüngung diskontinuierlich sind, so daß zwischen den einzelnen zu erfassenden Schaltstellungen S₁₋₅ Stege 11, die zur Erhöhung der Stabilität der Geberscheibe 4 dienen, verbleiben. Im Bereich der Stege 11 befindet sich keine Schaltstellung, so daß sich eine Schaltstellungserfassung in diesen Bereichen erübrigt. Die Ausnehmungen 8 sind im Bereich einer vorgesehenen Schaltstellung S_{1-5,} in der der Schalthebel 2 verrastet fixiert ist, angeordnet und erstrecken sich sowohl in die eine als auch in die andere Richtung (entlang der y-Achse), wobei zweckmäßigerweise die vorgesehene Schaltstellung S₁₋₅ mittig zwischen der Erstreckung einer Ausnehmung 8 in Verjüngungsrichtung (y-Richtung) vorgesehen ist. Eine solche Anordnung ist in Figur 2 dargestellt. Jede Schaltstellung S₁₋₅ ist durch ein eigenes charakteristisches Breitenintervall in x-Richtung in Abhängigkeit von dem Verjüngungsgrad der Hell-Dunkel-Übergangsspuren 8, 9 und der Erstreckung einer Ausnehmung 8 in y-Richtung definiert. Da die Auflösung der optischen Sensorzeile 6 einem Mehrfachen der in einer Schaltstellung S₁₋₅ stattfindenden Verjüngung entspricht, ist das Informationssignal einer Schaltstellung S₁₋₅ der Verjüngung entsprechend redundant ausgebildet. Ein solches Verfahren eignet sich insbesondere auch für ein sogenanntes "shift-by-wire"-System an welches erhöhte Sicherheitsanforderung gestellt sind.

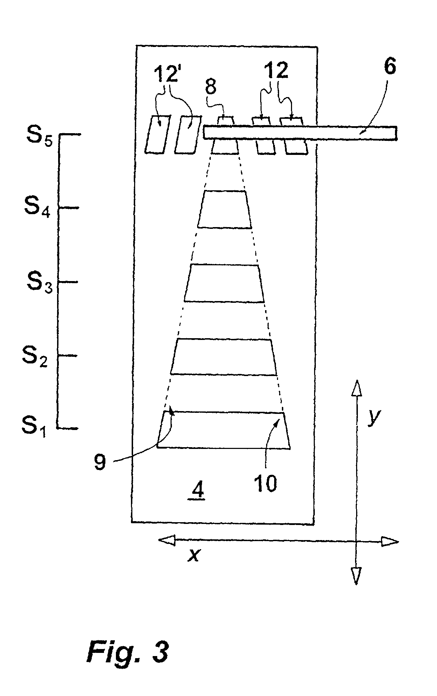

In y-Richtung weist die Schalteinrichtung 1 fünf Schaltstellungen S₁₋₅ auf. In der Schaltstellung S₅ ist der Schalthebel 1 zusätzlich in x-Richtung bewegbar. In dieser Schaltstellung S₅ ist ein manuelles Schalten der einzelnen Gänge bei gleichzeitiger Sperrung der automatischen Schaltfunktionen möglich. Das Herauf- bzw. Herunterschalten erfolgt durch eine sogenannte "Tippbewegung" auf den Schalthebel 2, so daß dieser auf der x-Achse entweder in die eine oder andere Richtung bewegt wird. Durch diese Tippbewegung wird die Geberscheibe 4 bezüglich der Längserstreckung der optischen Sensorzeile 6 versetzt, wie dies in Figur 3 dargestellt ist.

Parallel zu der Ausnehmung 8 dieser Schaltstellung S₅ sind weitere Licht durchlassende Ausnehmungen 12, 12' in die Geberscheibe 4 eingebracht. Eine Schaltstellungserfassung bei einer Bewegung des Schalthebels 2 entlang der x-Achse führt dazu, daß auch die von den Ausnehmungen 12 oder 12' erzeugten Lichtspuren bzw. deren Hell-Dunkel-Übergänge von der optischen Sensorzeile 6 abtastbar. Mit diesen Ausnehmungen 12, 12' ist eine Informationsredundanz erhältlich, so daß von der optischen Sensorzeile 6 nicht nur der Versatz der abgetasteten Schaltstellung S₅ entlang der x-Achse sondern auch das Hinzutreten bzw. das aus dem Abtastbereich Heraustreten dieser Hell-Dunkel-Übergänge erfaßt wird.

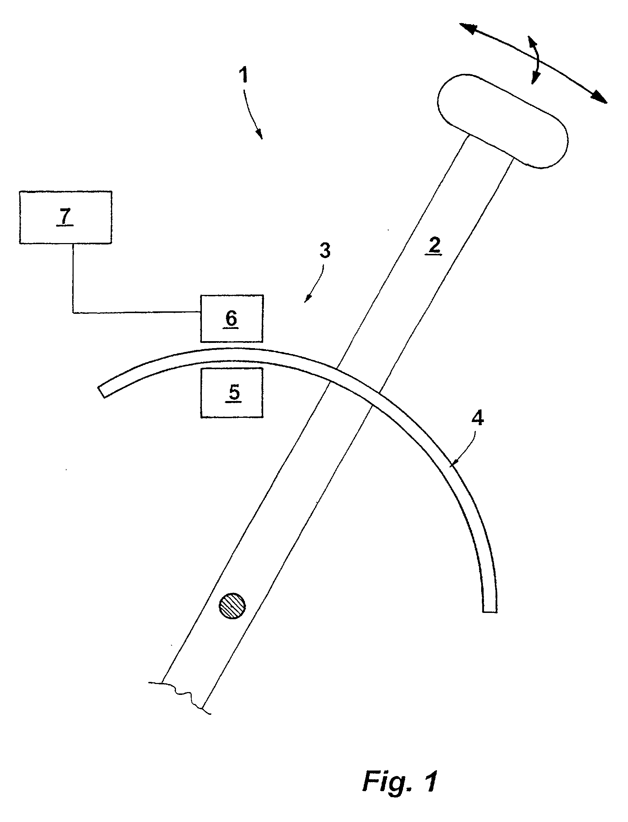

Die Abtastung eines Lichtfensters, wie in den Figuren 1 bis 3 gezeigt, sowohl entlang der y-Achse als auch entlang der x-Achse ermöglicht eine Software-mäßige Justage der Schaltstellungserfassungsvorrichtung 3 hinsichtlich einer Einstellung des exakten Schaltpunktes. Entsprechend alterungsadaptierbar ist eine solche Vorrichtung, bezüglich alterungs- oder abnutzungsbedingten Veränderungen in der Zwangsführung bzw. Fixierung des Schalthebels 2, wodurch sich der eigentliche Schaltpunkt geringfügig verändern kann.

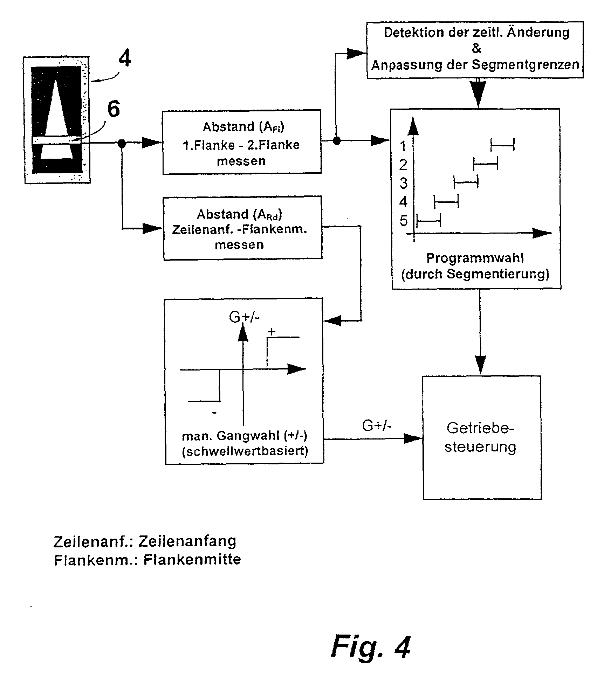

Eine Schaltstellung S₁₋₅ wird, wie in Figur 4 gezeigt, dadurch eingerichtet, daß der Abstand A_{Fl} der Hell-Dunkel-Übergänge - der Flanken 13, 13' (vgl. Figur 2a) - in einer Schaltstellung S₁₋₅ mittels der optischen Sensorzeile 6 abgetastet und in der Prozessoreinheit 7 ausgewertet wird. Dieser Wert wird in einem Speichermodul hinterlegt. Die Abstandsbestimmung der beiden Hell-Dunkel-Übergänge erfolgt durch Ermittlung der jeweiligen Flanke 13, 13', wobei ein Interpolationsalgorithmus zur Subpixel-genauen Auflösung eines Hell-Dunkel-Überganges verwendet werden kann. Mit Hilfe einer zeitlich rekursiven Filterung sind Änderungen hinsichtlich der Schalthebelfixierung in einer Schaltstellung detektierbar. Entsprechend kann bei einer Änderung des tatsächlichen Schaltpunktes in einer Schaltstellung
S₁₋₅ diese verglichen und angepaßt werden. Durch Bewegen des Schalthebels 2 entlang der y-Achse wird das Automatikgetriebe in die unterschiedlichen Fahrprogramme eingestellt. Dabei stellt die Fahrstufe S, den Parkmodus, die Fahrstufe S₂ die Rückwärtsfahrstufe, die Fahrstufe S₃ den Leerlauf, die Fahrstufe S₄ die das Automatikgetriebe verwendende Fahrstufe und die Fahrstufe S₅ diejenige Fahrstufe dar, bei der ein manuelles Durchschalten der einzelnen Gänge bei gleichzeitiger Sperrung der automatischen Schaltfunktion möglich ist.

In der Schaltstellung S₅ erfolgt durch Betätigen des Schalthebels 2 entlang der x-Achse eine Herausbewegung der Geberscheibe 4 aus ihrer ansonsten mittigen Anordnung hinsichtlich der optischen Sensorzeile 6. Zur Erfassung des Versatzes des Hell-Dunkel-Überganges der Ausnehmung 8 in dieser Schaltstellung wird der Abstand A_{Rd} zwischen dem Zeilenanfang der optischen Sensorzeile 6 und der Hell-Dunkel-Übergangsmitte (Flankenmitte) gemessen. In Abhängigkeit davon, ob der Abstand A_{Rd} bezüglich der Nullstellung des Schalthebels 2 durch Herauf- bzw. Herunterschalten größer oder kleiner ist bzw. wird, wird in Abhängigkeit von der Versatzstrecke ein Schwellwert basiertes Signal an die Getriebesteuerung gegeben. Der Schwellwert ist so gewählt, daß dieser deutlich größer ist als die im Fahrbetrieb maximal auftretenden Vibrationen des Schalthebels 2. Durch zusätzliches Erfassen der durch die Ausnehmungen 12 bzw. 12' hervorgerufenen Hell-Dunkel-Übergänge wird eine zusätzliche Sicherheit geschaffen, um eine solche Schaltstellungserkennung mit ausreichender Sicherheit treffen zu können. In einem der Prozessoreinheit 7 zugeordneten Zählglied erfolgt eine Aufsummierung der entlang der x-Achse getätigten Schaltbewegungen, so daß ein mehrstufiges Heraufschalten durch mehrfaches Betätigen des Schalthebels 2 in die eine Richtung (jeweils um denselben Betrag) und ein Herunterschalten durch Betätigen des Schalthebels 2 in die andere Richtung möglich ist und durch das Zählglied die aktuelle Schaltstellung ausgegeben wird.

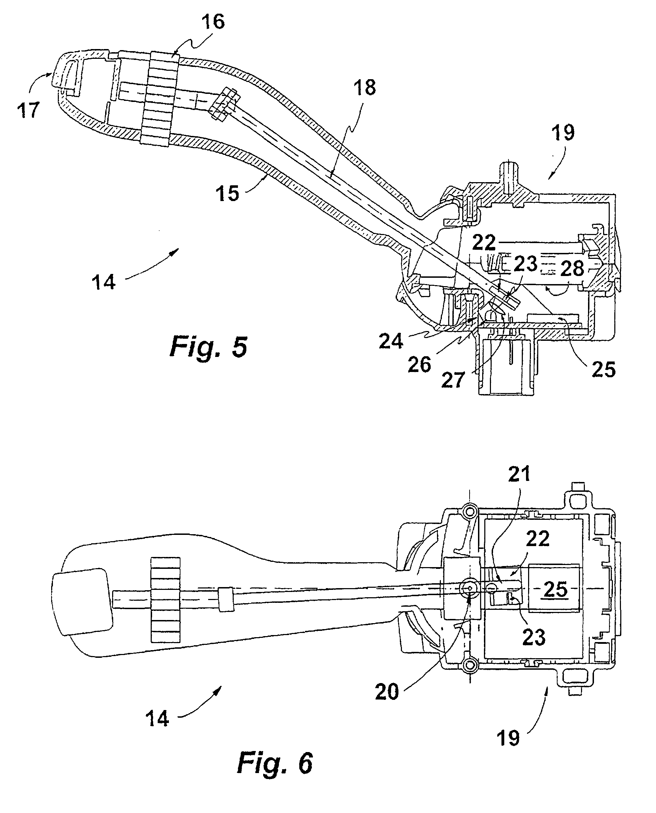

Ein weiteres Ausführungsbeispiel der erfindungsgemäßen Schaltstellungserfassungsvorrichtung ist in Figur 5 in einem Lenkstockschalter 14 dargestellt. Der Lenkstockschalter 14 umfaßt einen Schalterarm 15 zum Bedienen des Lenkstockschalters 14. Dem Schalterarm 15 sind unterschiedliche Bedienelemente 16, 17 zugeordnet, mittels denen bestimmte Aktoren eines Kraftfahrzeuges betätigt werden können. Bei dem Bedienelement 16 handelt es sich um einen Drehschalter; bei dem Bedienelement 17 handelt es sich um einen Taster. Der Schalterarm 15 selbst ist in verschiedener Richtung bewegbar und dient somit insgesamt ebenfalls als Schaltmittel. Der Schalterarm 15 umfaßt zum Übertragen seiner eigenen Bewegungen sowie der Bewegungen der Bedienelemente 16, 17 einen Übertragungshebel 18, der wie in Figur 6 gezeigt, schwenkbar im Gehäuse 19 des Lenkstockschalters 14 im Drehpunkt 20 angelenkt ist. Zum Übertragen der Bewegung der Taste 17 ist der Übertragungshebel 18 mit dem Drehpunkt auch längsverschiebbar angeordnet.

Dem Übertragungshebel 18 ist ausgehend von Drehpunkt 20 gegenüberliegend ein kurzer Hebelarm 21 angeordnet, dessen freies Ende eine Geberscheibe 22 trägt. In die Geberscheibe 22 ist zur Erzeugung einer Lichtstruktur ein Schlitz 23 angebracht. Aus der in Figur 6 gezeigten Draufsicht wird erkennbar, daß die Bewegungen des Übertragungshebel 18 Bewegungen der Geberscheibe 22 und somit des Schlitzes 23 zur Folge haben.

Unter Bezug auf Figur 5 wird die Anordnung zwischen der Geberscheibe 22 und einer die Geberscheibe 22 mit Licht beaufschlagende Lichtquelle 24 sowie eines die Lichtstruktur abtastenden Flächensensors 25 deutlich. Als Lichtquelle 24 dient bei dem in Figur 5 gezeigten Ausführungsbeispiel eine Leuchtdiode 26, deren punktförmig imitiertes Licht durch eine Linse 27 in paralleles Licht gebündelt wird. Das parallele Licht bestrahlt die Geberscheibe 22 von ihrer der Lichtquelle 24 zugewandten Seite. Aufgrund des Schlitzes 23 wird eine schlitzförmige Lichtstruktur erzeugt, deren Lichtstrahlen an einer von der anderen Seite der Geberscheibe 22 beabstandeten Spiegelfläche 28 reflektiert werden, bevor die Lichtstrahlen der Lichtstruktur auf die photosensitive Oberfläche des Flächensensors 25 auftreffen. Eine solche Anordnung ist insbesondere bei sehr beengten Einbauverhältnissen, wie dies am Beispiel des Lenkstockschalters 14 gezeigt ist, vorteilhaft. Ferner werden durch diese Vergrößerung des Abstandes zwischen der Geberscheibe 22 und dem Flächensensor 25 kleinere Bewegungen der Geberscheibe 22 vergrößert.

In einer weiteren Ausgestaltung kann vorgesehen sein, daß in dem Gehäuse 19 des Lenkstockschalters 14 nicht der Flächensensor 25 sondern nur das freie Ende eines lichtleitenden Faserbündels angeordnet ist. Mit ihrem anderen Ende beaufschlagt ein solches Faserbündel dann die photosensitive Seite eines Flächensensors.

Entsprechend kann auch das für eine solche Anordnung benötigte Licht über einen optischen Lichtleiter zugeführt werden. Derartige Ausgestaltungen sind insbesondere hinsichtlich der Recycelfähigkeit derartiger Schalter, etwa Lenkstockschalter zweckmäßig, da diese dann keine das Recycling erschwerende elektronischen Bauteile enthalten. Lichtquelle und Flächensensor können dann beispielsweise an einer zentralen Stelle im Kraftfahrzeug angeordnet sein.

### Zusammenstellung der Bezugszeichen

- 1: Schalteinrichtung
- 2: Schalthebel
- 3: Schaltstellungserfassungsvorrichtung
- 4: Geberscheibe
- 5: Beleuchtungseinrichtung
- 6: Optische Sensorzeile
- 7: Prozessoreinheit
- 8: Ausnehmung
- 9: Hell-Dunkel-Übergangsspur
- 10: Hell-Dunkel-Übergangsspur
- 11: Steg
- 12: Ausnehmung
- 12': Ausnehmung
- 13: Flanke des Signals
- 13': Flanke des Signals
- 14: Lenkstockschalter
- 15: Schalterarm
- 16: Bedienelement
- 17: Bedienelement
- 18: Übertragungshebel
- 19: Gehäuse
- 20: Drehpunkt
- 21: Kurzer Hebelarm
- 22: Geberscheibe
- 23: Schlitz
- 24: Lichtquelle
- 25: Flächensensor
- 26: Leuchtdiode
- 27: Linse
- 28: Spiegelfläche

- A_{Fl}: Flankenabstand
- A_{Rd}: Abstand Zeilenanfang - Flankenmitte
- S₁: Schaltstellung
- S₂: Schaltstellung
- S₃: Schaltstellung
- S₄: Schaltstellung
- S₅: Schaltstellung

## Patentansprüche

1. Vorrichtung zum Erfassen von Schaltstellungen eines mechanisch betätigbaren, zwangsgeführten Schaltmittels mit
- einem eine Schaltstellung (S₁₋₅) anzeigenden Geberelement (4, 22) und einem photoelektrischen, eine Vielzahl von einzelnen Bildpunkten aufweisenden Sensorarray (6, 25), wobei entweder das Geberelement (4, 22) oder das Sensorarray (6, 25) an die Bewegung des Schaltmittels (2, 15) gekoppelt und das jeweils andere Element (6, 25 bzw. 4, 22) diesbezüglich ortsfest angeordnet ist,
- einer elektronischen Prozessoreinheit (7), der die Ausgangssignale des Sensorarrays (6, 25) zugeführt werden,
- mit welchem Geberelement (4, 22) durch Lichtbestrahlung eine für die jeweilige Schaltstellung (S₁₋₅) charakteristische Lichtstruktur (8) auf der photosensitiven Oberfläche des Sensorarrays (6, 25) abgebildet ist und das Sensorarray (6, 25) bezüglich seines Auflösungsvermögen zur Erfassung der Unterschiede der die einzelnen Schalterstellungen (S₁₋₅) kennzeichnenden Lichtstrukturen (8) ausgelegt ist,
- wobei das Sensorarray (6, 25) zum Abtasten der Lichtstruktur (8, 23) dergestalt angeordnet ist, daß durch die Ausgangssignale des Sensorarrays (6, 25) die relative Position zwischen dem Sensorarray (6, 25) und dem Geberelement (4, 22) und somit die jeweilige Schaltstellung (S₁₋₅) des Schaltmittels (2, 15) eindeutig festgelegt ist.

2. Schaltstellungserfassungsvorrichtung nach Anspruch 1, **dadurch gekennzeichnet, daß** die Lichtstruktur (8) zumindest zwei voneinander beabstandete, bezüglich ihres Abstandes konvergierende Hell-Dunkel-Übergangsspuren (9, 10) aufweist, bezüglich denen das Sensorarray (6) dergestalt angeordnet ist, daß bei einer Relativbewegung zwischen dem Geberelement (4) und dem Sensorarray (6) der sich ändernde Abstand der Hell-Dunkel-Übergangsspuren (9, 10) von dem Sensorelement (6) abtastbar ist.

3. Schaltstellungserfassungsvorrichtung nach Anspruch 2, **dadurch gekennzeichnet, daß** die beiden Hell-Dunkel-Übergangsspuren (9, 10) durch eine sich in Bewegungsrichtung hin verjüngende Lichtspur (8) gebildet sind, deren Hell-Dunkel-Übergangsspuren (9, 10) die beiden aufeinanderzulaufenden Konturen der Lichtspur sind.

4. Schaltstellungserfassungsvorrichtung nach Anspruch 2 oder 3, **dadurch gekennzeichnet, daß** die Hell-Dunkel-Übergangsspuren (9, 10) in Richtung ihrer Verjüngung diskontinuierlich sind.

5. Schaltstellungserfassungsvorrichtung nach Anspruch 4, **dadurch gekennzeichnet, daß** die Hell-Dunkel-Übergänge der Hell-Dunkel-Übergangsspuren (9, 10) bei jeder zu erfassenden Schaltstellung (S₁₋₅) auf einen Abschnitt im Bereich dieser Schaltstellung (S₁₋₅) begrenzt sind.

6. Schaltstellungserfassungsvorrichtung nach einem der Ansprüche 2 bis 5, **dadurch gekennzeichnet, daß** das Sensorelement (6) und das Geberelement (4) in einer Richtung, die quer zur Ausrichtung der konvergierenden Hell-Dunkel-Übergangsspuren (9, 10) verläuft, relativ zueinander bewegbar angeordnet sind.

7. Schaltstellungserfassungsvorrichtung nach einem der Ansprüche 2 bis 6, **dadurch gekennzeichnet, daß** benachbart zu einer oder mehreren der Hell-Dunkel-Übergangsspuren (9, 10) weitere Lichtstrukturen (12, 12') angeordnet sind.

8. Schaltstellungserfassungsvorrichtung nach einem der Ansprüche 1 bis 7, **dadurch gekennzeichnet, daß** als Sensorarray eine optische Sensorzeile (6) vorgesehen ist.

9. Schaltstellungserfassungsvorrichtung nach einem der Ansprüche 1 bis 7, **dadurch gekennzeichnet, daß** als Sensorarray ein Flächensensor (25) vorgesehen ist.

10. Schaltstellungserfassungsvorrichtung nach Anspruch 9, **dadurch gekennzeichnet, daß** zur Erzeugung der Lichtstruktur in dem Geberelement (22) ein Schlitz (23) eingebracht ist.

11. Schaltstellungserfassungsvorrichtung nach einem der Ansprüche 1 bis 10, **dadurch gekennzeichnet, daß** die die Lichtstruktur bildenden Lichtstrahlen vor ihrem Auftreffen auf die photosensitive Oberfläche des Sensorarray (25) an einer oder mehreren reflektierenden Oberflächen (28) gebrochen werden.

12. Schaltstellungserfassungsvorrichtung nach einem der Ansprüche 1 bis 11, **dadurch gekennzeichnet, daß** zwischen dem Geberelement und dem Sensorarray ein Faserbündel angeordnet ist, in welches die die Lichtstruktur bildenden Lichtstrahlen zum Weiterleiten desselben an das Sensorarray eingekoppelt werden.

13. Verfahren zum Erfassen von Schaltstellungen eines mechanisch betätigbaren, zwangsgeführten, mehraxial bewegbaren Schaltmittels mit einem optoelektronischen Positionserfassungssystem, umfassend ein an eine Prozessoreinheit (7) angeschlossenes photoelektrisches Sensorarray (6) und ein durch eine Lichtstruktur erzeugte Hell-Dunkel-Übergangsspuren (9, 10) aufweisendes Geberelement (4), welche Lichtstruktur zumindest zwei voneinander beabstandete, bezüglich ihres Abstandes konvergierende Hell-Dunkel-Übergangsspuren (9, 10) aufweist, beinhaltend folgende Schritte:
- Bestimmen des Abstandes (A_{Fl}) der Hell-Dunkel-Übergangssspuren (9, 10) aus dem Ausgangssignal des Sensorarrays (6, 25) in einer Schaltstellung (S₁₋₅),
- Zuordnen dieses Abstandes einer vorbestimmten Schaltstellung (S₁₋₅),
- Ansteueren eines oder mehrerer Aktoren entsprechend der bestimmten Schaltstellung (S₁₋₅),
- Bewegen des Schaltmittels (2) in einer zur Achse der konvergierenden Hell-Dunkel-Übergangsspuren (9, 10) unterschiedlichen Richtung (Versatzrichtung) und
- Bestimmen der Bewegungsrichtung und des Bewegungsweges des Versatzes der von dem Sensorarray (6) abgetasteten Lichtstruktur relativ zum Sensorarray (6).

14. Verfahren nach Anspruch 13, **dadurch gekennzeichnet, daß** die Abtastung der Versatzrichtung und des Versatzweges zwischen dem Geberelement (4) und dem Sensorarray (6) durch Abtastung des Pixelversatzes einer von Ausnehmungen (12, 12') erzeugten Lichtspur erfolgt.

15. Verfahren nach Anspruch 14, **dadurch gekennzeichnet, daß** die Abtastung der Versatzrichtung und des Versatzweges zwischen dem Geberelement (4) und dem Sensorarray (6) durch Abtastung des Abstandes A_{Rd} der durch die beiden Signalflanken 13, 13' gebildeten Flankenmitte zum Zeilenanfang des Sensorarray (6) erfolgt.

16. Verfahren nach einem der Ansprüche 13 bis 15, **dadurch gekennzeichnet, daß** die Abtastung der Versatzrichtung und des Versatzweges zwischen dem Geberelement (4) und dem Sensorarray (6) durch eine Erfassung und Abtastung weiterer, parallel zur ersten Lichtstruktur angeordneter Lichtstrukturen (12,12') erfolgt.

17. Verfahren nach einem der Ansprüche 13 bis 16, **dadurch gekennzeichnet, daß** sich an den Schritt der Versatzerfassung eine Beaufschlagung eines Zählgliedes mit den Versatzdaten anschließt.

## Claims

1. Apparatus for detecting switching positions of a mechanically actuatable, positively guided switching means, including
- a transducer (4, 22) which indicates a switching position (S₁₋₅), and a photoelectric sensor array (6, 25), which has a plurality of individual image points, either the transducer (4, 22) or the sensor array (6, 25) being linked with the movement of the switching means (2, 15), and the respective other component part (6, 25 or respectively 4, 22) being disposed in a stationary manner relative thereto,
- an electronic processor unit (7), the output signals of the sensor array (6, 25) being supplied to said unit,
- by means of which transducer (4, 22) a light structure (8), which is characteristic for the respective switching position (S₁₋₅), is illustrated on the photosensitive surface of the sensor array (6, 25) by light radiation, and the sensor array (6, 25), in respect of its resolution, is designed to detect the differences between the light structures (8) **characterising** the individual switch positions (S₁₋₅),
- wherein, in order to scan the light structure (8, 23), the sensor array (6, 25) is disposed in such a manner that the relative position between the sensor array (6, 25) and the transducer (4, 22), and hence the respective switching position (S₁₋₅) of the switching means (2, 15), is clearly established by the output signals of the sensor array (6, 25).

2. Switching position detecting apparatus according to claim 1, **characterised in that** the light structure (8) has at least two light-to-dark transitional tracks/traces (9, 10), which are spaced from each other and converge in respect of their spacing, the sensor array (6) being disposed in respect of said tracks in such a manner that, during a relative movement between the transducer (4) and the sensor array (6), the varying spacing between the light-to-dark transitional tracks (9, 10) is scannable by the sensor member (6).

3. Switching position detecting apparatus according to claim 2, **characterised in that** the two light-to-dark transitional tracks (9, 10) are formed by a light track (8), which tapers when viewed with respect to the direction of movement, the light-to-dark transitional tracks (9, 10) of said light track being the two contours of the light track which travel towards each other.

4. Switching position detecting apparatus according to claim 2 or 3, **characterised in that** the light-to-dark transitional tracks (9, 10) are discontinuous in the direction of their tapering.

5. Switching position detecting apparatus according to claim 4, **characterised in that**, during each switching position (S₁₋₅) to be detected, the light-to-dark transitions of the light-to-dark transitional tracks (9, 10) are limited to a portion in the region of this switching position (S₁₋₅).

6. Switching position detecting apparatus according to one of claims 2 to 5, **characterised in that** the sensor member (6) and the transducer (4) are disposed so as to be displaceable relative to each other in a direction which extends transversely relative to the orientation of the converging light-to-dark transitional tracks (9, 10).

7. Switching position detecting apparatus according to one of claims 2 to 6, **characterised in that** additional light structures (12, 12') are disposed adjacent to one or more of the light-to-dark transitional tracks (9, 10).

8. Switching position detecting apparatus according to one of claims 1 to 7, **characterised in that** an optical sensor line (6) is provided as the sensor array.

9. Switching position detecting apparatus according to one of claims 1 to 7, **characterised in that** a sheet sensor (25) is provided as the sensor array.

10. Switching position detecting apparatus according to claim 9, **characterised in that** a slot (23) is provided in order to produce the light structure in the transducer (22).

11. Switching position detecting apparatus according to one of claims 1 to 10, **characterised in that** the light rays, forming the light structure, are refracted at one or more reflective surfaces (28) prior to their encountering the photosensitive surface of the sensor array (25).

12. Switching position detecting apparatus according to one of claims 1 to 11, **characterised in that** a fibre bundle is disposed between the transducer and the sensor array, the light rays which form the light structure being introduced into said bundle to pass said bundle to the sensor array.

13. Method of detecting switching positions of a mechanically actuatable, positively guided switching means, which is displaceable in a multi-axial manner, by using an optoelectronic position detecting system, which includes a photoelectric sensor array (6), which communicates with a processor unit (7), and a transducer (4), which has light-to-dark transitional tracks (9, 10) produced by a light structure, which light structure has at least two light-to-dark transitional tracks (9, 10), which are spaced apart from each other and converge in respect of their spacing, said method comprising the followings steps:
- determining the spacing (A_{F1}) between the light-to-dark transitional tracks (9, 10) from the output signal of the sensor array (6, 25) in one switching position (S₁₋₅),
- associating this spacing with a predetermined switching position (S₁₋₅),
actuating one or more actuators according to the predetermined switching position (S₁₋₅),
- moving the switching means (2) in a direction (offset direction), which varies relative to the axis of the converging light-to-dark transitional tracks (9, 10), and
- determining the direction of movement and the path of movement of the offset arrangement of the light structure, which is scanned by the sensor array (6), relative to the sensor array (6).

14. Method according to claim 13, **characterised in that** the scanning of the offset direction and of the offset path between the transducer (4) and the sensor array (6) is effected by scanning the offset pixel arrangement of a light track produced by recesses (12, 12').

15. Method according to claim 14, **characterised in that** the scanning of the offset direction and of the offset path between the transducer (4) and the sensor array (6) is effected by scanning the spacing (A_{Rd}) between the edge centre, formed by the two signal edges (13, 13') and the beginning of the lines of the sensor array (6).

16. Method according to one of claims 13 to 15, **characterised in that** the scanning of the offset direction and of the offset path between the transducer (4) and the sensor array (6) is effected by a detection and scanning of additional light structures (12, 12') disposed parallel to the first light structure.

17. Method according to one of claims 13 to 16, **characterised in that** an actuation of a counting member with the offset data communicates with the offset detection step.

## Revendications

1. Circuit de détection de la position de commutation d'un commutateur actionné mécaniquement et guidé comportant :
- un élément codeur (4, 22) indiquant une position de commutation (S₁₋₅) et un capteur photoélectriques (6, 25) constitué d'un grand nombre de points d'image individuels, l'élément codeur (4, 22) ou le capteur (6, 25) étant couplé(e) aux mouvements du commutateur (2, 15), l'autre élément correspondant (6, 25 ou 4, 22) étant alors fixe,
- un module processeur (7) auquel sont amenés les signaux de sortie du capteur (6,25),
- l'élément codeur (4, 22) servant à projeter par illumination sur la surface photosensible d'un capteur (6, 25) une structure lumineuse (8) caractéristique de la position de commutation (S₁₋₅) correspondante, le capteur (6, 25) étant conçu du point de vue potentiel de résolution pour permettre la détection des différences des structures lumineuses (8) caractérisant les différentes positions de commutation (S₁₋₅),
- le capteur (6, 25) destinée à identifier la structure lumineuse (8, 23) étant disposée de manière à permettre l'identification univoque à partir des signaux émis par le capteur (6, 25) de la position relative de l'élément codeur (4, 22) par rapport au capteur (6, 25) et donc de la position de commutation correspondante (S₁₋₅) du commutateur (2, 15).

2. Circuit de détection de la position de commutation selon revendication 1, **caractérisé en ce que** la structure lumineuse (8) présente au moins deux pistes de transition clair-obscur (9, 10) écartées l'une de l'autre mais convergentes et par rapport auxquelles le capteur (6) est disposé afin que, pour tout mouvement relatif entre l'élément codeur (4) et le capteur (6), il soit possible de détecter la variation de l'intervalle entre les pistes de transition clair-obscur (9, 10) et l'élément capteur (6).

3. Circuit de détection de la position de commutation selon revendication 2, **caractérisé en ce que** les deux pistes de transition clair-obscur (9, 10) sont constituées par une piste lumineuse (8) se rétrécissant dans le sens du déplacement et dont les pistes de transition clair-obscur (9, 10) correspondent aux deux contours convergents de la piste lumineuse.

4. Circuit de détection de la position de commutation selon revendication 2 ou 3, **caractérisé en ce que** les pistes de transition clair-obscur (9, 10) présentent une structure discontinue dans le sens de leur rétrécissement.

5. Circuit de détection de la position de commutation selon revendication 4, **caractérisé en ce que** les transitions clair-obscur des pistes de transition clair-obscur (9, 10) sont limitées, pour chacune des positions de commutation (S₁₋₅) à détecter, à une certaine partie de la zone de ces positions de commutation (S₁₋₅).

6. Circuit de détection de la position de commutation selon l'une des revendications 2 à 5, **caractérisé en ce que** l'élément capteur (6) et l'élément codeur (4) sont disposés selon une direction perpendiculaire à l'orientation des pistes de transition clair-obscur convergentes (9, 10) et soient mobiles l'un par rapport à l'autre.

7. Circuit de détection de la position de commutation selon l'une des revendication 2 à 6, **caractérisé en ce que** d'autres structures lumineuses (12, 12') sont disposées à proximité immédiate d'une ou plusieurs des pistes de transition clair-obscur (9, 10).

8. Circuit de détection de la position de commutation selon l'une des revendications 1 à 7, **caractérisé en ce que** le capteur est constitué d'un capteur optique en ligne (6).

9. Circuit de détection de la position de commutation selon revendication 1, **caractérisé en ce que** le capteur est constitué d'un capteur à surface (25).

10. Circuit de détection de la position de commutation selon revendication 9, **caractérisé en ce que** la génération de la structure lumineuse est assurée par une fente (23) intégrée à l'élément codeur (22).

11. Circuit de détection de la position de commutation selon l'une des revendications 1 à 10, **caractérisé en ce que** les rayons lumineux constituant la structure lumineuse sont renvoyés par une ou plusieurs surfaces réfléchissantes (28) avant de frapper la surface photosensible du capteur (25).

12. Circuit de détection de la position de commutation selon l'une des revendications 1 à 11, **caractérisé en ce qu'**un faisceau de fibres optiques est disposé entre l'élément codeur et le capteur, dans lequel les rayons lumineux constituant la structure lumineuse sont injectés en vue de les transmettre au capteur.

13. Procédé de détection de la position de commutation d'un commutateur actionné mécaniquement, guidé en force et mobile selon plusieurs axes, au moyen d'un système optoélectronique de détection de position, comprenant un capteur photoélectrique (6) raccordée à un module processeur (7) ainsi qu'un élément codeur (4) générant des pistes de transition clair-obscur (9, 10) à partir d'une structure lumineuse elle-même constituée d'au moins deux pistes de transition clair-obscur (9, 10) convergentes du point de vue écartement, et assurant les étapes de traitement suivantes :
- détermination de l'écartement entre flancs (A_{Fl}) des pistes de transition clair-obscur (9, 10) à partir du signal de sortie émis par le capteur (6, 25) dans une position de commutation donnée (S₁₋₅),
- affectation de cette distance à une position de commutation déterminée (S₁₋₅),
- pilotage d'un ou plusieurs actionneurs en fonction de la position de commutation ainsi définie (S₁₋₅),
- déplacement du commutateur (2) dans une direction différente (sens de décalage) par rapport à l'axe des pistes de transition clair-obscur (9, 10) convergentes,
- détermination de la direction du mouvement et de la course de décalage latéral par rapport au capteur (6) de la structure lumineuse analysée par ladite structure lumineuse (6).

14. Procédé selon revendication 13, **caractérisé en ce que** la détection de la direction de décalage et de la course de décalage entre l'élément codeur (4) et le capteur (6) s'effectue par analyse du décalage des pixels illuminés par l'une des découpures (12, 12').

15. Procédé selon la revendication 14, **caractérisé en ce que** la détection de la direction de décalage et de la course de décalage entre l'élément codeur (4) et le capteur (6) s'effectue par détermination de la distance A_{Rd} séparant le milieu du plateau déterminé par les deux flancs de signal (13, 13') du début de la ligne du capteur (6).

16. Procédé selon l'une des revendications 13 à 15, **caractérisé en ce que** la détection de la direction de décalage et de la course de décalage entre l'élément codeur (4) et le capteur (6) s'effectue par une détection et une analyse d'autres structures lumineuses (12, 12') disposées parallèlement à la première structure lumineuse.

17. Procédé selon l'une des revendications 13 à 16, **caractérisé en ce que** l'étape de la détection du décalage est suivie de la sollicitation d'un organe de comptage traitant l'information de décalage.
